# EUROPEAN PATENT APPLICATION

(11) **EP 4 610 585 A1**
(43) Date of publication of application: **03.09.2025**
(21) Application number: 25154401.1
(22) Date of filing: 28.01.2025
(51) Int. Cl.: F28D 15/02, F28F 1/32, G06F 1/20, H01L 23/367, H01L 23/467

(54) **COOLING SYSTEMS INCLUDING STACKS WITH FINS**

(30) Priority: 28.02.2024 WO PCT/CN2024/078940; 27.03.2024 US 202418618659
(71) Applicant: INTEL Corporation, Santa Clara, CA 95054 (US)
(72) Inventor: ZHOU, Songlin, Shanghai 200241 (CN); SUI, Linghe, Shanghai 200241 (CN); SHE, Hongjun, Shanghai 200241 (CN)
(74) Representative: 2SPL Patentanwälte PartG mbB

(57) **Abstract**

Cooling systems including stacks with shark fin surface features. An example compute device including a heat-producing component, a stack thermally coupled to the heat-producing component, the stack including a first plate, a second plate, the first plate and the second plate defining a channel therebetween, a fin extending from a surface of the first plate into the channel, the fin including a first end adjacent to the surface, a second end distal to the surface, a spine extending between the first end and the second end, the spine inclined at an angle relative to the surface, and a fan to direct air through the channel.

## Description

### FIELD OF THE DISCLOSURE

This disclosure relates generally to convection cooling systems and, more particularly, to cooling systems including stacks with fins.

### BACKGROUND

Convection-based cooling systems often include a base plate, which transfers heat from a heat-producing component, such as an integrated circuit. Some such convection cooling systems include heat pipes to transfer heat from the base plate to the fin structure. Convection-based cooling systems typically include fans, which drive a flow of air over the fin structure and transfer heat from the fin structure into the ambient environment.

### BRIEF DESCRIPTION OF THE DRAWINGS

FIG. 1 is a top view of an example cooling system including a stack implemented in accordance with teachings of this disclosure.
FIG. 2 is a perspective view of the stack of FIG. 1.
FIG. 3 is a perspective view of a fin of the array of fins of FIG. 2.
FIG. 4A is a schematic view of a flow through a prior fin structure.
FIG. 4B is a schematic view of an example flow through the stack of FIG. 2.
FIG. 5 is a perspective view of another fin implemented in accordance with teachings of this disclosure and that can be used in conjunction with the stack of FIG. 2.
FIG. 6 is a perspective view of another fin implemented in accordance with teachings of this disclosure and that can be used in conjunction with the stack of FIG. 2.

In general, the same reference numbers will be used throughout the drawing(s) and accompanying written description to refer to the same or like parts. The figures are not necessarily to scale.

### DETAILED DESCRIPTION

Many compute devices include cooling systems to cool the heat-producing components of the compute devices. Many of these prior cooling systems are convection-based and include base plates that abut a heat-producing component of the compute system and absorb heat therefrom via conduction. Some prior convection-based cooling systems include stacks of heat conducting plates that are thermally coupled to the base plate via heat pipes. Air can be driven through the stacks via a fan, which draws air from the ambient environment. As air is driven through the stack, heat is absorbed into the air from the stack via convection. The heat exchange efficiency of a stack is a parameter that affects the thermal capacity of the convection cooling system. The heat exchange efficiency of a stack in prior convection systems is based on the number of plates of the stack, the size of the gap(s) between the plates, and/or the thickness(es) of the plates. However, the tuning of these parameters in prior cooling systems can be limited by the packaging space available to the stack, the material(s) of the plates, and/or the impedance of the flow through the stack.

Prior stacks are susceptible to recirculation and/or other turbulent flow effects in portions of the stack distal to the outlet of the fan. Recirculation of air and turbulent effects within a stack can significantly reduce the heat exchange efficiency of the stack and decrease the thermal design power (TDP) of the compute device. Another challenge posed by prior stacks is the surface drag associated with the plates. Particularly, within the individual channels of the stacks, friction between the air and the plates causes the air near the plates to be comparatively hot and slow and air in the middle of the channel to be comparatively fast and cool. This temperature gradient can reduce the heat exchange efficiency of the stack.

Examples disclosed herein address one or more of the deficiencies described above and include convection-based cooling systems having stacks including fins based on the biomimetics of shark fins. Example fins disclosed herein include holes that enable the flow in a stack to move between adjacent channels of the stack. In some such examples disclosed herein, the holes in the fins balance pressure between adjacent channels. Example fins disclosed herein disrupt the flow of air over the surface of the fins and induce mixing between the comparatively slow hot air near the surface of the plates and the comparatively fast cool air in the middle of the channels of the stack. In some such examples disclosed herein, the mixing of air within the channels increases the heat exchange efficiency of the stack. Example fins disclosed herein mitigate recirculation effects (e.g., eddies, vortexes, whirlpools, etc.) at the inlet of the fin stacks, which increases the flow rate of air through the stacks. The example stacks disclosed herein do not have significantly increased manufacturing and/or material costs when compared to prior fin stacks. Example fin stacks disclosed herein increase the TDP of convection-based cooling systems when compared to prior convection cooling systems.

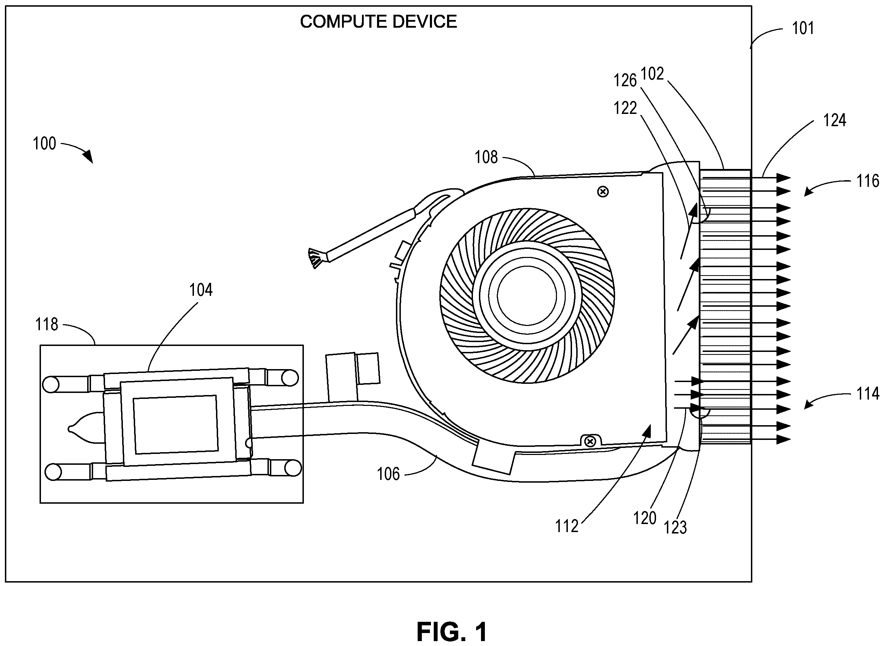

FIG. 1 is a top view of an example cooling system 100 including an example stack 102 implemented in accordance with teachings of this disclosure. In the illustrated example of FIG. 1, the cooling system 100 is disposed in an example compute device 101. In the illustrated example of FIG. 1, the cooling system 100 includes an example base plate 104, example heat pipes 106, and an example fan 108. In the illustrated example of FIG. 1, the fan 108 includes an example fan outlet 112. In the illustrated example of FIG. 1, the stack 102 includes an example first region 114 adjacent to the fan outlet 112 and an example second region 116 distal to the fan outlet 112.

In the illustrated example of FIG. 1, the cooling system 100 is incorporated into the compute device 101. The cooling system 100 cools the compute device 101 and dissipates heat generated by the operation of components (e.g., processors circuitry, electronics, motors, etc.) thereof. In some examples, the compute device 101 can be a laptop, a personal computer (e.g., a tower computer, etc.), a workstation, a notebook, a tablet, a server, and/or any other suitable type of compute device. In other examples, the cooling system 100 can be incorporated into any other suitable device that includes heat-generating device(s) and/or heat-generating portions (e.g., a refrigerator unit, an air conditioner, etc.). While the example cooling system 100 described herein is an air-cooling system, in other examples, the cooling system 100 can be a liquid cooling system (e.g., an immersion cooling system, etc.). In some such examples, a liquid (e.g., a refrigerant, distilled water, etc.) can be directed by the fan 108 and/or a pump through the stack 102.

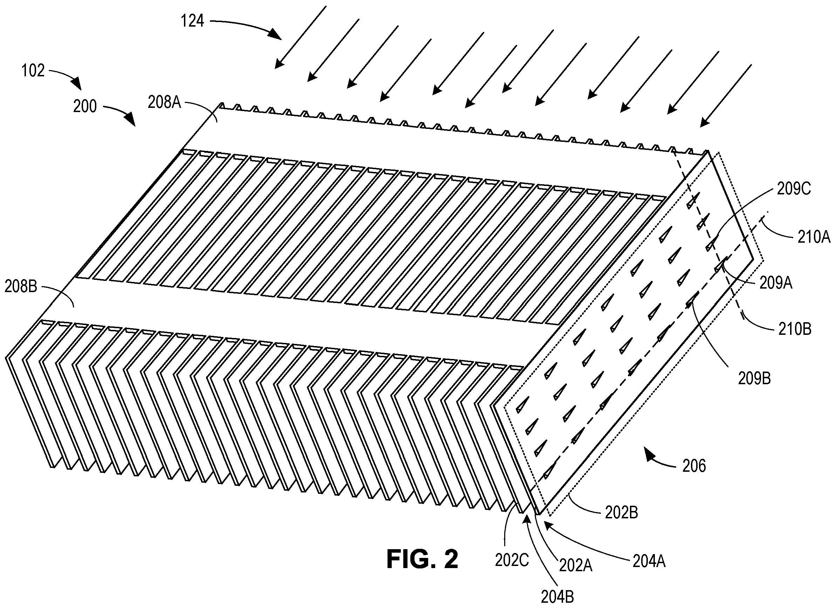

The stack 102 of this example is a mechanical structure that includes a plurality of plates disposed in parallel. The stack 102 absorbs heat from the heat pipes 106 and dissipates the heat into the air flowing through the stack 102 and into the ambient environment. The transfer of heat from the stack 102 into the air flowing therethrough cools one or more example heat producing component(s) 118 (e.g., processor circuitry, etc.) of the compute device 101. The stack 102 includes a plurality of fins (e.g., biomimetic shark fins shaped, etc.) that increase the heat exchange rate between the air flowing through the stack 102 and the plates of the stack 102. For example, some or all of the plates of the stack 102 of FIG. 1 can include fins that extend between individual ones of the plates of the stack 102. In some examples, the stack 102 includes (e.g., is composed of, etc.) a thermally conductive material (e.g., copper, aluminum, silver, etc.). An example implementation of the stack 102 is described in greater detail below in conjunction with FIG. 2.

The base plate 104 is a structural component that absorbs heat from the heat producing component(s) 118. In the illustrated example of FIG. 1, the base plate 104 contacts (e.g., abuts, engages with, etc.) and is in thermal contact with the heat producing component(s) 118. In some examples, a thermally conductive paste is disposed between the heat producing component(s) 118 and the base plate 104 to increase the rate of conduction between the base plate 104 and the heat producing component(s) 118. In some examples, the base plate 104 includes (e.g., is composed of, etc.) a thermally conductive material (e.g., copper, aluminum, etc.). In some examples, the heat producing component(s) 118 is a compute unit that performs operations for the compute device 101. In some such examples, the heat producing component(s) 118 can be one or more central processor unit(s) (CPU), one or more graphical processor unit(s) (GPU), one or more digital signal processor(s) (DSP), one or more data processing unit(s) (DPU), one or more tensor processing unit (TPU), and/or any other suitable integrated circuitry. Additionally or alternatively, the heat producing component(s) 118 can include other component(s), such as a motor, a fan, a compressor, a bearing, a heat-exchanger, etc.

The heat pipes 106 are thermally conductive structures that transfer (e.g., conduct, etc.) heat between the base plate 104 and the stack 102. In some examples, the heat pipes 106 include internal channels that include a fluid (e.g., ammonia, methanol, ethanol, water, mercury, etc.) that vaporizes as the fluid absorbs heat from the base plate 104. The vapor can travel to a portion of the heat pipes 106 adjacent to the stack 102, dissipate (e.g., conduct, transfer, etc.) heat into the stack 102, condense into a liquid, and return to a portion of the heat pipes 106 close to the base plate 104 (e.g., via gravity, via capillary action, etc.). In some examples, the body of the heat pipes 106 can include a highly conductive material, such as copper, aluminum, silver, etc. In some examples, the internal region(s) of the heat pipes 106 have a wick/capillary design (e.g., a grooved wick design, a sintered wick design, mesh-weave wick design, etc.). In some examples, the heat pipes 106 are absent. In some examples, the base plate 104 is directly coupled to the stack 102.

The fan 108 is a mechanical device that draws air in from the ambient environment of the compute device 101 and directs the air through the stack 102. In the illustrated example of FIG. 1, the fan 108 is a centrifugal fan. In other examples, the fan 108 is an axial fan. In some examples, the compute device 101 can include additional fans (e.g., a fan associated with a power supply of the compute device 101, etc.).

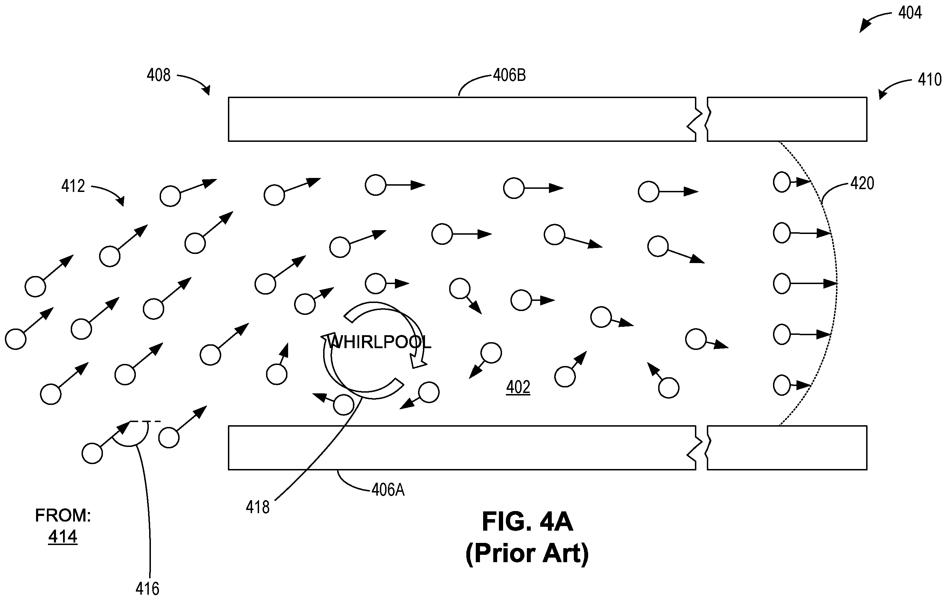

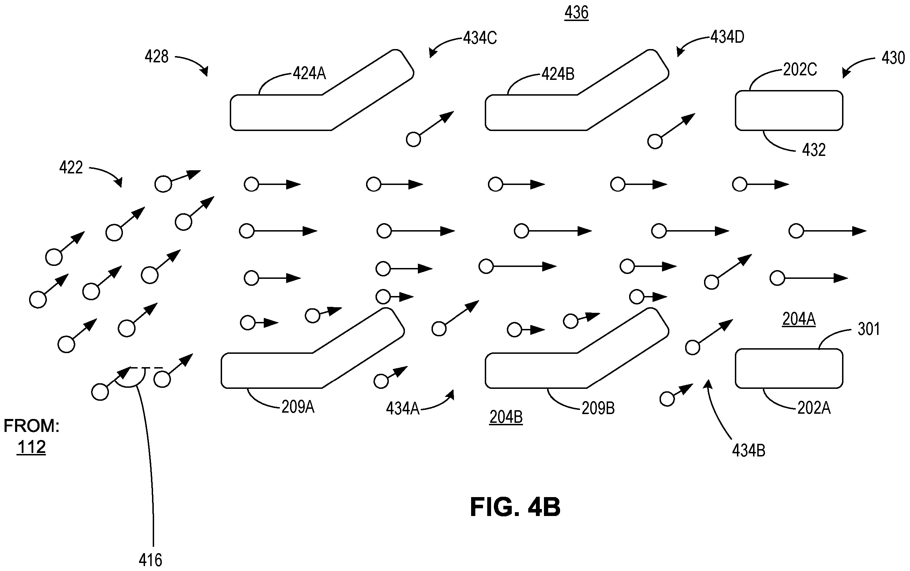

In the illustrated example of FIG. 1, the fan outlet 112 of the fan 108 is adjacent to the first region 114 of the stack 102 and distal to the second region 116 of the stack 102. In some examples, the position of the fan outlet 112 can increase the relative flow rate of air through the first region 114 and decrease the relative flow rate of air through the second region 116. In some such examples, the fins of the stack 102 can normalize (e.g., partially normalize, fully normalize, etc.) the pressure and flow rate of air between the regions 114, 116. In the illustrated example of FIG. 1, the air exiting the fan outlet 112 defines an example first flow vector 120 in the first region 114 and an example second flow vector 122 in the second region 116. In some examples, the first flow vector 120 forms an example first angle 123 with an example stack flow vector 124. In the illustrated example of FIG. 1, the second flow vector 122 forms an example second angle 126 with the stack flow vector 124. In the illustrated example of FIG. 1, the first angle 123 is approximately 180 degrees (e.g., the first flow vector 120 is substantially colinear with the stack flow vector 124, etc.). In the illustrated example of FIG. 1, the second angle 126 is an obtuse angle. The obtuse angle formed between the second flow vector 122 and the stack flow vector 124 causes recirculation effects within the stack 102 in the second region 116, which is mitigated by the presence of the fins of the stack 102. A prior stack including recirculation effects is described in conjunction in FIG. 4A. Example mitigation of such recirculation effects by example fins disclosed herein is described below in conjunction with FIG. 4B.

FIG. 2 is a perspective view of the stack 102 of FIG. 1 including a plurality of plates 200 implemented in accordance with teachings of this disclosure. In the illustrated example of FIG. 2, the plurality of plates 200 includes multiple plates such as an example first plate 202A, an example second plate 202B, an example third plate 202C, etc. In the illustrated example of FIG. 2, an example first channel 204A is defined between the first plate 202A and the second plate 202B. In the illustrated example of FIG. 2, an example second channel 204B is defined between the first plate 202A and the third plate 202C. In the illustrated example of FIG. 2, the second plate 202B is depicted via a dashed line and as transparent for visuality clarity only. In the illustrated example of FIG. 2, the first plate 202A includes an example plurality of fins 206. In the illustrated example of FIG. 2, the stack 102 includes an example stack flow vector 124 representing the flow of air through the stack 102 (e.g., as directed from the fan 108 of FIG. 1, etc.). Although this description is focused on 3 plates (e.g., the plates 202A, 202B, 202C, etc.) of the stack 102, it is to be understood to extend to similar features of other ones of the plates 200 of the stack 102.

The plurality of plates 200 are walls of the stack 102 that direct the flow of air through the stack 102. As used herein, the terms "sheet" and "plate" are used interchangeably to refer to the plates of the stacks described herein. The plates 200 can include (e.g., be composed of any suitable conductive material, etc.) including copper, aluminum, silver, steel, etc. In the illustrated example of FIG. 2, the plates 200 are evenly spaced. In other examples, some or all of the plates 200 are unevenly spaced. In the illustrated example of FIG. 2, the plates 200 have a consistent thickness. In other examples, some or all of the plates 200 have different thicknesses. In some examples, the spacing between the plates 200 (e.g., the width of the first channel 204A, etc.), the number of plates 200, and the thickness of the plates 200 can be selected based on the design parameters of the cooling system 100.

In the illustrated example of FIG. 2, the plates 200 include an example first lock mechanism 208A and an example second lock mechanism 208B. The lock mechanisms 208A, 208B couple the plurality of plates 200 into the stack 102. For example, the lock mechanisms 208A, 208B can include one or more end features of the stacks 102 (e.g., a plurality of bosses and corresponding openings, etc.) that are joined via a plurality of interference fits. In some such examples, the stack 102 can be formed via stamping and/or other sheeting-forming manufacturing methods. For example, the plates 200 of the stack 102 can be manufactured as a series of metal sheets (e.g., copper sheets, aluminum sheets, etc.) that are coupled via the locking mechanism 208A, 208B. In some such examples, the plurality of fins 206 can be formed during the stamping of the plates 200. In some such examples, the plates 200 that include the plurality of fins 206 do not have an increased material cost and/or manufacturing complexity when compared to a sheet without the plurality of fins 206. Additionally or alternatively, the lock mechanisms 208A, 208B can include one or more fasteners (e.g., screws, rivets, bolts, etc.), one or more weld surfaces that are joined via a weld, one or more chemical adhesives, etc. In some examples, the lock mechanisms 208A, 208B are absent. In some such examples, the stack 102 is an integral component manufactured via machining and/or additive manufacturing.

The fins 206 are surface features (e.g., ridges, etc.) of the first plate 202A that extend into the channel 204A. The fins 206 disrupt the flow of air through the channel 204A to increase the mixing of air within the first channel 204A and mitigate (e.g., reduce, prevent, etc.) recirculation effects (e.g., eddies, whirlpools, vortexes, etc.) within the first channel 204A. In some examples, the fins 206 include through-holes, which fluidly couple the channels 204A, 204B. While the fins 206 are depicted as a features of the first plate 202A, it should be appreciated the other ones of the plurality of plates 200 can include fins similar to the fins 206 (e.g., the second plate 202B, the third plate 202C, some or all of the other plates 200, a majority of the plates 200, the plates 200 associated with the second region 116 of FIG. 1, etc.). For example, the third plate 202C can include another plurality of fins that extend into the second channel 204B.

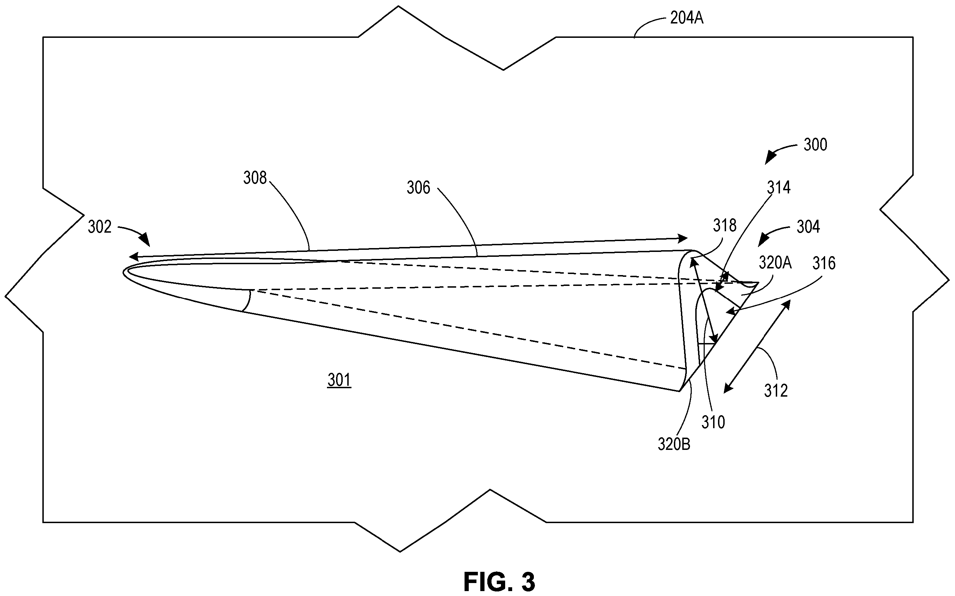

In the illustrated example of FIG. 2, the array of fins 206 includes 28 fins. In other examples, the first plate 202A can include a different number of fins (e.g., 1 fin, 10 fins, 20 fins, 40 fins, 100 fins, etc.). In some examples, the number of fins of the array of fins 206 can be selected based on the size of the plates 200. In the illustrated example of FIG. 2, each fin of the array of fins 206 has a same size and/or a same shape. In the illustrated example of FIG. 3, the fins 206 are generally V-shaped ridges formed in the first plate 202A. For example, the fins 206 are generally shark-fin shaped (e.g., biomimetic shaped like the first dorsal fin of shark, the portion of a shark that may been seen above the water when the shark swims near the surface of the water, etc.). In other examples, some or all of the fins 206 can have different size(s) and/or different shapes. An example fin of the fins 206 is described below in conjunction with FIG. 3.

In the illustrated example of FIG. 2, the fins 206 include an example first fin 209A, an example second fin 209B, and an example third fin 209C. In the illustrated example of FIG. 2, the first fin 209A is aligned with the second fin 209B along an example first axis 210A parallel to the stack flow vectors 124. In the illustrated example of FIG. 2 the first fin 209A is aligned with the third fin 209C along an example second axis 210B perpendicular to the first axis 210A and the stack flow vectors 124. In the illustrated example of FIG. 2, the fins 206 have a grid pattern (e.g., a uniform grid distribution, etc.). That is, the fins 206 are equally distributed along the first axis 210A and the fins 206 are equally distributed along the second axis 210B. In other examples, the fins 206 can have another uniform distribution (e.g., adjacent rows of the fins 206 are misaligned, adjacent columns of the fins 206 are misaligned, etc.). In other examples, the fins 206 can have a non-uniform distribution (e.g., randomly distributed, unevenly spaced, etc.). In some such examples, the first fin 209A and the second fin 209B are unaligned along the first axis 210A and the first fin 209A and the third fin 209C are unaligned along the second axis 210B.

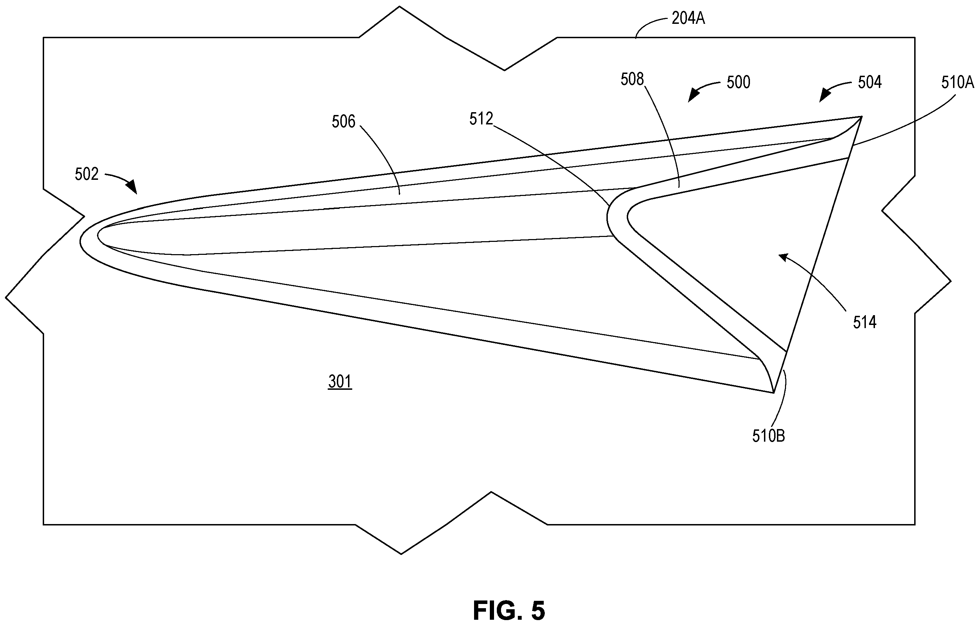

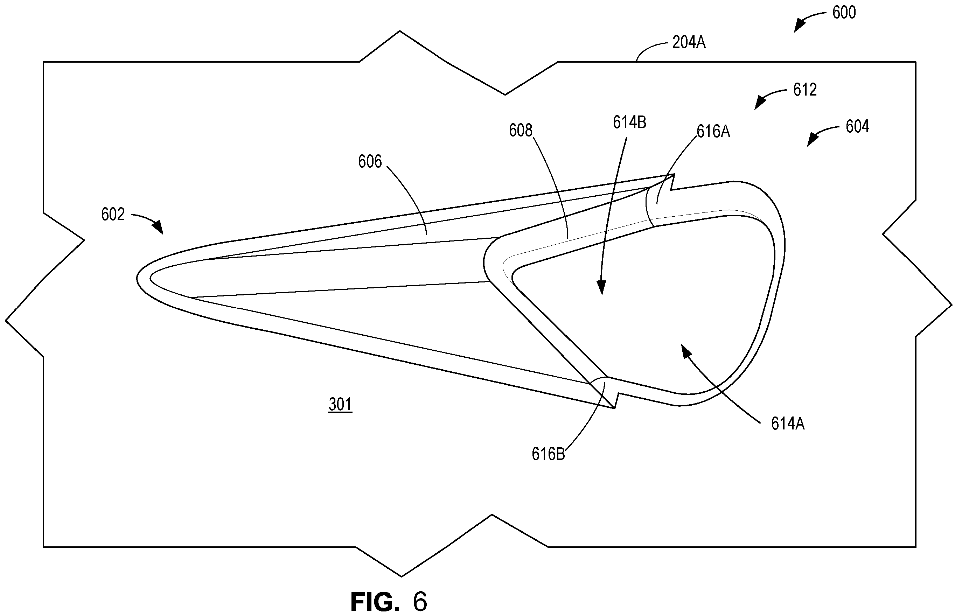

FIG. 3 is a perspective view of an example implementation of a fin 300 of the array of fins 206 of FIG. 2. In the illustrated example of FIG. 3, the fin 300 extends from an example surface 301 of the first plate 202A of FIG. 2 into the channel 204A. In the illustrated example of FIG. 3, the fin 300 includes an example first end 302, an example second end 304, and an example spine 306. As used herein, the spine 306 is interchangeable referred to as a "crest" of the fin 300 and a "spine" of the fin 300. In the illustrated example of FIG. 3, the spine 306 has an example length 308 and the second end 304 has an example height 310 and an example width 312. In the illustrated example of FIG. 3, the fin 300 has an example thickness 314. In the illustrated example of FIG. 3, the second end 304 includes an example hole 316. Alternative fins implemented in accordance with teachings of this disclosure are described below in conjunction with FIGS. 5 and 6.

In the illustrated example of FIG. 3, the first end 302 is adjacent to the surface 301 and the second end 304 is distal to the surface 301. For example, in the illustrated example of FIG. 3, the first end 302 is generally flush with the first surface 301 (e.g., the spine 306 is flush with the surface 301 at the first end 302, etc.) and the second end 304 is spaced from the surface 301 (e.g., the spine 306 is spaced from the first surface 301 at the second end 304 by the height 310, etc.). In this example, the spine 306 of the fin 300 that extends from the first end 302 to the second end 304 is inclined relative to the surface 301 (e.g., the spine 306 is disposed at an inclined angle relative to the surface 301, etc.) In this example, the spine 306 terminates and/or is flush with the surface 301 of the plate 202A at the first end 302 and slopes upward to the second end 304. In the illustrated example of FIG. 3, the spine 306 defines an acute angle relative to the surface 301 of the plate 202A (e.g., the angle defined between the spine 306 and the projection of the spine 306 on the surface 301, etc.). In other examples, the first end 302 is spaced from the first surface 301. In some such examples, the first end 302 can include a hole similar to the hole 316.

In the illustrated example of FIG. 3, the displacement of the fin 300 increases linearly along the spine 306 between the first end 302 and the second end 304 (e.g., the slope of the spine 306 is linear between the first end 302 and the second end 304, etc.). In other examples, the spine 306 of the fin 300 can include a curve (e.g., a logistic curve, a logarithmic curve, a quadratic curve, an exponential curve, an irregular curve, etc.) between the first end 302 and the second end 304. In the illustrated example of FIG. 3, the displacement of the fin 300 from the surface 301 increases monotonically from the first end 302 to the second end 304. In other examples, the displacement of the fin 300 from the surface 301 increases non-monotonically from the first end 302 and the second end 304 (e.g., spine 306 includes corrugations, etc.).

The hole 316 enables air to pass through the fin 300 and the first plate 202A. The hole 316 is disposed at the second end 304 and extends beneath the spine 306 into the plate 202A. As used herein, the terms "hole" and "opening" are used interchangeable to refer to the opening in the second end 304. That is, the hole 316 enables fluid communication through first plate 202A and between the channels on both sides of the first plate 202A (e.g., the channels 204A, 204B of FIG. 3, etc.). In the illustrated example of FIG. 3, the hole 316 is generally triangularly shaped (e.g., the hole 316 is a triangle, the hole 316 is V-shaped, etc.). In other examples, the hole 316 can have any other suitable shape depending on the shape of the second end 304 (e.g., polygonally shaped, circularly shaped, ovoidal shaped, C-shaped, D-shaped, etc.). In some examples, the hole 316 can extend onto the surface 301 of the first plate 202A. In other examples, the hole 316 is absent. In some such examples, the second end 304 can be solid and/or otherwise impermeable to flow over the surface 301. In some such examples, adjacent channels of the stack 102 are not in fluid communication.

In the illustrated example of FIG. 3, the second end 304 includes an example edge 318. In the illustrated example of FIG. 3, the edge 318 includes an example first edge end 320A and an example second edge end 320B. In the illustrated example of FIG. 3, the edge ends 320A, 320B are disposed at the surface 301. In the illustrated example of FIG. 3, the edge 318 is generally V-shaped. That is, the edge ends 320A, 320B and the spine 306 at the second end 304 form a V. In the illustrated example of FIG. 3, the edge 318 of the second end 304 and the hole 316 are generally symmetrical about the spine 306. For example, the portion of the edge 318 extending between the spine 306 and the first edge end 320A is symmetrical to the portion of the edge 318 extending between the spine 306 and the second edge end 320B. In other examples, the edge 318 and the hole 316 are asymmetrical about the spine 306.

In the illustrated example of FIG. 3, the spine 306 has the length 308 between the first end 302 and the second end 304. In some examples, the length 308 of the fin 300 can be based on the length of the stack 102 (e.g., the length of the stack 102 along the first axis 210A of FIG. 2, etc.). In the illustrated example of FIG. 3, the fin 300 has a consistent thickness (e.g., the thickness 314, etc.). For example, the thickness 314 of the fin 300 can be based on the thickness of the first plate 202A. For example, if the fin 300 is formed in the plate 202A via stamping, the fin 300 and the first plate 202A have an approximately same thickness. In other examples, the plate 202A and the fin 300 can have any other suitable thickness. In the illustrated example of FIG. 3, at the second end 304, the spine 306 is spaced the height 310 from the surface 301. In some examples, the width of the channels of stack 102 is approximately 1 millimeter (mm) in width. In some such examples, the height 310 can be less than or equal to 0.2 millimeters (mm). Additionally or alternatively, the height 310 can be less than or equal to one-tenth of the length 308 (e.g., the length 308 is ten times greater than the height 310, etc.). The width 312 is the distance between the edge ends 320A, 320B. In some examples, the width 312 is approximately equal to twice the height 310. In other examples, the width 312 can have any other suitable dimensions. In some examples, the length 308, the height 310, the width 312, and/or the thickness 314 can be selected based on the compute device associated with the stack 102 (e.g., the compute device 101 of FIG. 1, etc.), the size of the stack 102, the cooling fluid (e.g., air, immersion cooling fluid, etc.), and/or the velocity of the fluid within the stack 102.

FIG. 4A is a schematic view of a cross-sectional schematic diagram of a channel 402 of a prior fin stack 404. In FIG. 4A, the channel 402 is defined between a first plate 406A and a second plate 406B. In the illustrated example of FIG. 4A, the channel 402 includes a channel inlet 408 and a channel outlet 410. A flow 412 exits a fan outlet 414 (e.g., an outlet similar to the fan outlet 112, etc.) and enters the channel inlet 408. In FIG. 4A, the flow 412 is depicted as a series of discrete air particles with corresponding velocity vectors. The depiction of the flow 412 as discrete particles is not to scale and is included for visual clarity and explanatory purposes only. In FIG. 4A, the channel 402 is not aligned with the fan outlet such that the flow 412 forms an angle 416 with the plate 406A (e.g., an angle similar to the second angle 126 of FIG. 1, etc.). That is, the channel 402 is positioned in the prior fin stack 404 in a position distal to the fan outlet 414 (e.g., the channel 402 is positioned in region similar to the second region 116, etc.).

As the flow 412 enters the channel inlet 408, the flow 412 encounters the second plate 406B (e.g., the downstream plate, the plate more distal to the fan outlet 414, etc.), which increases the pressure of the flow near the second plate 406B compared to the first plate 406A. The pressure differential creates a vortex 418 near the first plate 406A (e.g., the upstream plate, the plate more adjacent to the fan outlet 414, etc.). The vortex 418 reduces the pressure recovery of the channel 402 and the overall flow rate of the flow 412 through the channel 402. The reduced pressure recovery and flow rate through the prior channel 402 decreases the heat exchange efficiency of the prior stack 404. Additionally, the formation of vortexes in channels of the prior stack 404 distal to the fan outlet 414 creates an even exit flow rate and exit pressure along the length of the prior stack 404. Because drag is proportional to flow velocity squared, the uneven pressure distribution of the prior stack 404 disproportionately increases drag within the prior stack 404, when compared to a stack with an even pressure and flow velocity distribution (e.g., stack 102 of FIG. 1, etc.).

In FIG. 4A, downstream in the channel 402, the flow 412 assumes a flow velocity distribution 420. The flow velocity distribution 420 is caused by surface friction (e.g., drag, viscosity force, etc.) between the flow 412 and the plates 406A, 406B. In the flow velocity distribution 420, the velocity of the 412 near the center of the channel 402 is substantially faster than the velocity of the flow 412 near the plates 406A, 406B. Because the flow 412 absorbs heat via convection from the plates 406A, 406B, the portion of the flow 412 near the plates 406A, 406B is substantially warmer than the portion of the flow 412 in the center of the channel 402. While some heat is transferred between the air molecules within the channel 402, when the flow 412 exits the channel outlet 410, the flow 412 at the center of the channel 402 can be substantially cooler than the air near the plates 406A, 406B. Because heat exchange rate is proportionally to the difference in temperature between the mediums exchanging heat, the comparatively greater temperature of the flow 412 near the plates 406A, 406B reduces the heat exchange rate of the prior stack 404 and the flow 412.

FIG. 4B is a schematic view of a cross-sectional diagram of an example flow 422 through the channel 204A of FIG. 2. In the illustrated example of FIG. 4B, the channel 204A is positioned distal to the fan outlet 112 of the fan 108 of FIG. 1. That is, the channel 204A is positioned in the second region 116 of FIG. 1. In the illustrated example of FIG. 4B, the first channel 204A includes the first plate 202A of FIG. 2, the third plate 202C of FIG. 2, the first fin 209A of FIG. 2, and the second fin 209B. In the illustrated example of FIG. 4B, the third plate 202C includes an example third fin 424A and an example fourth fin 424B. In the illustrated example of FIG. 4B, the flow 422 enters the channel 204A and forms the second angle 126 of FIG. 1 with the plates 202A, 202B. In the illustrated example of FIG. 4B, the channel 204A has an example channel inlet 428 and an example channel outlet 430.

In the illustrated example of FIG. 4B, the fins 209A, 209B extend from the first plate 202A into the channel 204A. In the illustrated example FIG. 4B, the first plate 202A is upstream of the second plate 202B relative to the fan outlet 112. That is, the fins 209A, 209B extend from the downstream plate (e.g., the plate closer to the fan outlet 112 of the fan 108, etc.) into the channel 204A. In the illustrated example of FIG. 4B, the ends of the fins 209A, 209B that extend from the surface 301 of the first plate 202A (e.g., the ends similar to the first end 302 of FIG. 3, etc.) are positioned closer to the channel inlet 428 than the channel outlet 430. Similarly, the ends of the fins 209A, 209B that are displaced from the surface 301 of the first plate 202A (e.g., the ends similar to the second end 304 of the FIG. 3, etc.) are positioned closer to the channel outlet 430 than the channel inlet 428. In some such examples, the orientation of the fins 209A, 209B causes the portion of the flow 422 near the surface 301 within the first channel 204A to move along the surface of the fins 209A, 209B and mix with the portion of the flow near the center of the first channel 204A. The mixing of the flow 422 causes a more uniform temperature distribution of the flow 422 within the first channel 204A. That is, the fins 209A, 209B facilitate the mixing of the comparatively slow hot portion of the flow 422 near the surface 301 of the first plate 202A and an example second surface 432 of the second plate 202B with the comparatively fast and cold portion of the flow 422 in the center of the first channel 204A. The mixing of the flow 422 increases the temperature differential between the portion of the flow 422 near the surfaces 301, 432 and the plates 202A, 202C, which increases the heat transfer rate (e.g., the rate of convection, etc.) therebetween.

In the illustrated example of FIG. 4B, the fins 209A, 209B, 424A, 424B include an example first hole 434A, an example second hole 434B, an example third hole 434C, and an example fourth hole 434D, respectively. The holes 434A, 434B, 434C, 434D are similar to the hole 316 of FIG. 3. In the illustrated example of FIG. 4B, the holes 434A, 434B enable fluid communication between the first channel 204A and the second channel 204B. In the illustrated example of FIG. 4B, the holes 434C, 434D enable fluid communication between the first channel 204A and an example third channel 436 formed between the third plate 202C and an adjacent plate of the stack 102. That is, the holes 434A, 434B, 434C, 434D enable some of the flow 422 to move from the first channel 204A into the second channel 204B and/or the third channel 436. The movement of the flow 422 between the channels 204A, 204B, 436 normalizes (e.g., equalizes, etc.) the pressure between the channels 204A, 204B, 436. The normalization of pressure between the channels 204A, 204B, 436 normalizes the flow velocity in the channels 204A, 204B, 436, which reduces the overall drag associated with the flow of air through the stack 102 when compared to the flow through the prior stack 404 of FIG. 4A. In some examples, the holes 434A, 434B, 434C, 434D create a negative pressure zone near the holes 434A, 434B, 434C, 434D due to the Bernoulli effect, which accelerates the flow 422 away from the surfaces 301, 432 and further facilitates the mixing of the flow 422 within the first channel 204A.

The reduced drag associated with the stack 102 decreases the power demand of the fan 108 and/or reduces the energy of the flow 422 lost to surface friction, drag, and/or viscous effects. In some such examples, the reduction in energy losses of the flow 422 increases the overall flow rate of the flow 422 within the stack 102, which increases the heat transfer rate (e.g., the rate of convection, etc.) between the stack 102 and the flow 422. Additionally or alternatively, the reduction in energy losses of the flow 422 enables a smaller and/or less powerful fan to be used in the cooling system 100 when compared to a cooling system including the prior stack 404 of FIG. 4A.

In some examples, the shape of the fins 209A, 209B, 424A, 424B increases the area of the plates 202A, 202B exposed to the flow 422. For example, the presence of the fins 209A, 209B, 424A, 424B can increase the area of the plates 202A, 202B exposed to the flow 422 by 5% when compared to the prior plates 406A, 406B of FIG. 4A. In some such examples, the increased area of the fins 209A, 209B increases the heat exchange rate between the stack 102 and the flow 422 when compared to the prior stack 404 of FIG. 4A. Additionally, the fins 209A, 209B disrupt the flow 422 near the channel inlet 428, which disrupts the formation of vortices within the channel 204A. In some examples, the normalization of the pressure and/or the flow rate between the channels 204A, 204B, 436 associated with the holes 434A, 434B, 434C, 434D further reduces (e.g., retards, prevents, mitigates, etc.) recirculation and other turbulent flow effects within the channel 204A (e.g., vortexes, whirlpools, eddies, etc.). As such, the fins 209A, 209B, 424A, 424B and the holes 434A, 434B, 434C, 434D mitigate (e.g., reduce, prevent, etc.) the formation of vortexes within the channel 204A and the associated pressure and velocity reduction.

FIG. 5 is a perspective view of another example fin 500 implemented in accordance with teachings of this disclosure and that can be used in conjunction with the stack 102 of FIG. 2. The fin 500 is similar to the fin 300 of FIG. 3, except as noted otherwise. In some examples, the fin 500 can implement one or more of the array of fins 206 of FIG. 2 (e.g., one or more of the fins 209A, 209B, 209C, etc.). In the illustrated example of FIG. 5, the fin 500 includes an example first end 502, an example second end 504, and an example crest 506, which are similar to the first end 302, the second end 304, and the spine 306, respectively. In the illustrated example of FIG. 5, the second end 504 includes an example edge 508, which includes an example first edge end 510A and an example second edge end 510B, which are similar to first edge end 320A and the second edge end 320B, respectively, except as noted otherwise. In the illustrated example of FIG. 5, the edge 508 includes an example crest edge 512. In the illustrated example of FIG. 5, the fin 500 includes an example hole 514, which is similar to the hole 316, respectively.

In the illustrated example of FIG. 5, the crest edge 512 is disposed closer toward the first end 502 than the edge ends 510A, 510B. That is, the crest edge 512 is inset toward the first end 502. In the illustrated example of FIG. 5, the insetting of the crest edge 512 increases the relative size of the hole 514. In other examples, the crest edge 512 can be displaced away from the first end 502. That is, the crest edge 512 can be displaced forward of the second end 504, such that crest edge 506 is upstream of the edge ends 510A, 510B. Similarly to the fin 300 of FIG. 3, the fin 500 is generally V-shaped. The fin 500 has a comparatively deeper (e.g., stronger, etc.) V-shape than the fin 300 of FIG. 3. The comparatively larger size of the hole 514 increases the flow rate between adjacent channels of the stack 102 when compared to the hole 316 of the fin 300 of FIG. 3.

FIG. 6 is a perspective view of another example fin 600 implemented in accordance with teachings of this disclosure and that can be used in conjunction with the stack 102 of FIG. 2. The fin 600 is similar to the fin 300 of FIG. 3, except as noted otherwise. In some examples, the fin 600 can implement one or more of the array of fins 206 of FIG. 2 (e.g., one or more of the fins 209A, 209B, 209C, etc.). In the illustrated example of FIG. 6, the fin 600 includes an example first end 602, an example second end 604, and an example crest 606, which are similar to the first end 302, the second end 304, and the spine 306, respectively, except as noted otherwise. In the illustrated example of FIG. 6, the second end 604 includes an example edge 608. In the illustrated example of FIG. 6, the fin 600 includes an example hole 612, which is similar to the hole 316 of FIG. 3. In the illustrated example of FIG. 6, the hole 612 includes an example first hole portion 614A in the second end 604 and an example second hole portion 614B on the surface 301. As used herein, the hole portions 614A, 614B are also referred to interchangeably as "holes" (e.g., the first hole portion 614A is a first hole, the second hole portion 614B is a second hole, etc.), openings (e.g., the first hole portion 614A is a first opening, the second hole portion 614B is a second opening, etc.), and opening portions (e.g., the first hole portion 614A is a first opening portion, the second hole portion 614B is a second opening portions, etc.). In the illustrated example of FIG. 6, the first hole portion 614A and the second hole portion 614B are a single hole (e.g., the hole portions 614A, 614B are continuous, etc.). In other examples, the hole portions 614A, 614B are discrete holes (e.g., the a portion of the plate 202A separates the hole portions 614A, 614B, etc.). In the illustrated example of FIG. 6, the edge 608 extends around both of the hole portions 614A, 614B. In the illustrated example of FIG. 6, the hole portions 614A, 614B are separated by an example first junction 616A and an example second junction 616B. In the illustrated example of FIG. 6, the junctions 616A, 616B are disposed at the interface between the second end 604 and the surface 301. In the illustrated example of FIG. 6, the junctions 616A, 616B define an obtuse angle between the surface 301 and the second end 604. In other examples, the junctions 616A, 616B can define a right angle and/or an acute angle.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

Examples disclosed herein include stacks with 3D shark fin perforations that can be used in conjunction with prior fin designs. Examples disclosed herein can be used in conjunction with any cooling systems that include fin structures (e.g., any device that includes a fan and stack, etc.). For example, the fin structures disclosed herein can be used in conjunction with notebook computers, desktops, and workstations. Examples disclosed herein increase the performance (e.g., the efficiency, the cooling capacity, etc.) of air-cooled computing systems. Examples disclosed herein increase the thermal capacity and thermal design power of cooling systems including such stacks. Some example stacks disclosed herein increase the thermal design power (TDP) of compute devices by approximately 7%. Examples disclosed herein do not increase the material cost or manufacturing time of stacks when compared to prior fin designs.

Cooling systems including stacks with fins are disclosed herein. Further examples and combinations thereof include the following:
Example 1 includes a compute device including a heat-producing component, a stack thermally coupled to the heat-producing component, the stack including a first plate, a second plate, the first plate and the second plate defining a channel therebetween, a fin extending from a surface of the first plate into the channel, the fin including a first end adjacent to the surface, a second end distal to the surface, a spine extending between the first end and the second end, the spine inclined at an angle relative to the surface, and a fan to direct air through the channel.
Example 2 includes the compute device of any preceding example, wherein the channel includes an inlet adjacent to the fan, and an outlet adjacent to the fan, the first end closer to the inlet than the outlet.
Example 3 includes the compute device of any preceding example, wherein the first plate is adjacent to the fan and the second plate is distal to the fan.
Example 4 includes the compute device of any preceding example, wherein the fin further includes an opening at the second end.
Example 5 includes the compute device of any preceding example, wherein the opening is triangular.
Example 6 includes the compute device of any preceding example, wherein the opening includes a first opening portion in the fin, and a second opening portion on the surface.
Example 7 includes the compute device of any preceding example, wherein the first end is flush with the surface and the second end is displaced from the surface.
Example 8 includes the compute device of any preceding example, wherein the fin is a first fin, the stack further including a second fin extending from the first plate into the channel, the second fin aligned with the first fin along a first axis, and a third fin extending from the first plate into the channel, the third fin aligned with the first fin along a second axis perpendicular to the first axis.
Example 9 includes the compute device of any preceding example, wherein the fin is a first fin, the channel is a first channel and the stack further includes a third plate, the first plate between the second plate and the third plate, the third plate and the first plate defining a second channel, and a second fin extending from the third plate into the second channel.
Example 10 includes the compute device of any preceding example, wherein the spine extends monotonically between the first end and the second end.
Example 11 includes the compute device of any preceding example, wherein the spine extends linearly between the first end and the second end.
Example 12 includes a thermally conductive stack comprising a first plate, a second plate, the first plate and the second plate defining a channel, and a fin extending from a surface of the first plate into the channel, the fin including a first end adjacent to the surface, a second end distal to the surface, and a spine extending between the first end and the second end, the spine disposed at an incline angle relative to the surface.
Example 13 includes the thermally conductive stack of any preceding example, wherein the second end includes a V-shaped opening.
Example 14 includes the thermally conductive stack of any preceding example, wherein the V-shaped opening extends through the first plate.
Example 15 includes the thermally conductive stack of any preceding example, wherein the V-shaped opening includes a first opening in the second end, and a second opening in the surface.
Example 16 includes the thermally conductive stack of any preceding example, wherein the first plate further includes a plurality of fins, the plurality of fins including the fin.
Example 17 includes the thermally conductive stack of any preceding example, wherein the plurality of fins have a grid pattern on the first plate.
Example 18 includes the thermally conductive stack of any preceding example, wherein the fin is a first fin, the channel is a first channel and the thermally conductive stack further includes a third plate, the first plate between the second plate and the third plate, the third plate and the second plate defining a second channel, and a second fin extending into the second channel.
Example 19 includes the thermally conductive stack of any preceding example, wherein the fin increases a mixing of a flow in the channel.
Example 20 includes the thermally conductive stack of any preceding example, wherein the spine extends monotonically between the first end and the second end.
Example 21 includes the thermally conductive stack of any preceding example, wherein the spine extends linearly between the first end and the second end.
Example 22 includes the thermally conductive stack of any preceding example, wherein the spine defines an acute angle with the surface of the first plate.
Example 23 includes a thermally conductive sheet of a cooling system, the thermally conductive sheet comprising a first fin extending from a surface of the thermally conductive sheet, the first fin including a first end flush with the surface, a second end displaced from the surface, and a spine extending between the first end and the second end, and a second fin extending from the surface having a same shape as the first fin.
Example 24 includes the thermally conductive sheet of any preceding example, wherein the first fin includes an edge at the second end, the edge including a third end at the surface, and a fourth end at the surface, the spine inset toward the first end relative to the third end and the fourth end.
Example 25 includes the thermally conductive sheet of any preceding example, wherein the second end is spaced a height from the thermally conductive sheet, the spine having a length, and the spine is at least ten times greater than the height.
Example 26 includes the thermally conductive sheet of any preceding example, wherein the second end includes a opening extending through the thermally conductive sheet.
Example 27 includes the thermally conductive sheet of any preceding example, wherein the opening includes an edge, the edge including a junction having an obtuse angle.
Example 28 includes the thermally conductive sheet of any preceding example, wherein the thermally conductive sheet has a first thickness, and the first fin has a second thickness substantially equal to the first thickness.
Example 29 includes the thermally conductive sheet of any preceding example, wherein the first fin is shark-fin shaped.
Example 30 includes the thermally conductive sheet of any preceding example, wherein the spine extends monotonically between the first end and the second end.
Example 31 includes the thermally conductive sheet of any preceding example, wherein the spine defines an acute angle with the surface.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A thermally conductive stack comprising:
a first plate;
a second plate, the first plate and the second plate defining a channel; and
a fin extending from a surface of the first plate into the channel, the fin including:
a first end adjacent to the surface;
a second end distal to the surface; and
a spine extending between the first end and the second end, the spine disposed at an incline angle relative to the surface.

2. The thermally conductive stack of claim 1, wherein the second end includes a V-shaped opening.

3. The thermally conductive stack of claim 2, wherein the V-shaped opening extends through the first plate.

4. The thermally conductive stack of claim 3, wherein the V-shaped opening includes:
a first opening in the second end; and
a second opening in the surface.

5. The thermally conductive stack of any preceding claim, wherein the first plate further includes a plurality of fins, the plurality of fins including the fin.

6. The thermally conductive stack of any preceding claim, the channel is a first channel and the thermally conductive stack further includes a third plate, the first plate between the second plate and the third plate, the third plate and the second plate defining a second channel.

7. The thermally conductive stack of claim 6, wherein the fin is a first fin and further including a second fin extending into the second channel.

8. The thermally conductive stack of any preceding claim, wherein the fin increases a mixing of a flow in the channel.

9. The thermally conductive stack of any preceding claim, wherein the spine extends monotonically between the first end and the second end.

10. The thermally conductive stack of claim 9, wherein the spine extends linearly between the first end and the second end.

11. The thermally conductive stack of any preceding claim, wherein the first end is flush with the surface and the second end is displaced from the surface.

12. The thermally conductive stack of any preceding claim, wherein the first fin includes an edge at the second end, the edge including:
a third end at the surface; and
a fourth end at the surface, the spine inset toward the first end relative to the third end and the fourth end.

13. A compute device including:
a heat-producing component;
the thermally conductive stack of any preceding claim; and
a fan to direct air over the thermally conductive stack.

14. The compute device of claim 13, wherein the channel includes:
an inlet adjacent to the fan; and
an outlet adjacent to the fan, the first end closer to the inlet than the outlet.

15. The compute device of claim 14, wherein the first plate is adjacent to the fan and the second plate is distal to the fan.
